# EUROPEAN PATENT APPLICATION

(11) **EP 1 686 423 A2**
(43) Date of publication of application: **02.08.2006**
(21) Application number: 05257746.7
(22) Date of filing: 15.12.2005
(51) Int. Cl.: G03F 7/00, G03F 9/00

(54) **Alignment system used in nano-imprint lithography and nano imprint lithography method using the alignment system**

(30) Priority: 31.01.2005 KR 2005008749
(71) Applicant: Samsung Electronics Co., Ltd., Yeongtong-gu Suwon-si, Gyeonggi-do (KR)
(72) Inventor: Sang-jun,Choi c/o 210-1902 Samsung Reamian 2-cha, Yongin-si, Gyeonggi-do (KR); Jung-hyun, L. c/o 106-803 Taeyoung Lesvill Apt., Yongin-si, Gyeonggi-do (KR); Suk-won, L., 132-2003 Hwanggol Maeul 1-danji Apt., Suwon-si, Gyeonggi-do (KR); Moon-gu, L. c/o 702 Ingye Charmant, Suwon-si, Gyeonggi-do (KR)
(74) Representative: Greene, Simon Kenneth

(57) **Abstract**

An alignment system used in nano-imprint lithography and a nano-imprint lithography method using the alignment system are provided. The alignment system includes: a plurality of electron emission devices, which are provided in the mold and emit electrons; and a plurality of electrodes, which are provided to face the electron emission devices and at which the electrons emitted from the electron emission devices arrive. The mold and the substrate are aligned with each other by maximizing the amount of current in each of the electrodes.

## Description

The present invention relates to an alignment system used in nano-imprint lithography and a nano-imprint lithography method using the alignment system.

There are various lithography techniques that can be used to pattern the surface of a substrate in the manufacture of a semiconductor device.

Conventionally, optical lithography is widely used to manufacture patterns by coating a substrate with photoresist using light and etching the substrate. However, the size of patterns formed through optical lithography is limited due to optical diffraction. In addition, the resolution of patterns formed through optical lithography is proportional to the wavelength of light used in optical lithography. Thus, as the integration density of semiconductor devices increases, a light exposure technique using light with a shorter wavelength is needed to form finer patterns.

However, the shapes of photoresist patterns formed using optical lithography or the shapes of spaces between the photoresist patterns may undesirably change due to light interference. In particular, the critical dimensions of the photoresist patterns may become irregular due to light interference. If the critical dimensions of photoresist patterns become irregular depending on the properties of their underlying layers, the shapes of physical layer patterns formed using the photoresist patterns as a mask may not be the same as expected, thereby failing to realize desired line width that could have been realized otherwise.

In addition, photoresist may be eroded reacting with impurities generated in the process of manufacturing a semiconductor device, in which case, photoresist patterns are highly likely to be deformed. The erosion of photoresist may also deform physical layer patterns formed using the photoresist patterns.

Recently, next-generation lithography technology that can realize highly integrated semiconductor integrated circuits having a line width of several nanometers has been developed to solve the above problem.

Examples of next-generation lithography include electron beam lithography, ion beam lithography, extreme ultraviolet lithography, proximity X-ray lithography, and nano-imprint lithography.

A nano-imprint lithography system forms patterns by forming a mold of a relatively rigid material and putting marks on another material (e.g., a substrate) using the mold. Alternatively, the nano-imprint lithography system forms patterns by manufacturing a mold having a desired shape and filling the mold with a polymer material.

In order to pattern a portion of a substrate using nano-imprint lithography, a mask must be precisely aligned with the portion of the substrate, and thus, an alignment system is needed.

A conventional alignment system is disclosed in U.S. Patent No. 4,818,662. The conventional alignment system lays a mask over a wafer, applies an electron beam emitted from one of a plurality of electron beam guns installed therein into through holes of the mask and the wafer, detects the amount of current from the through holes of the mask and the wafer, and determines that the mask is precisely aligned with the wafer when the amount of current detected from the through holes of the mask and the wafer is maximized.

However, the conventional alignment system is required to maintain a vacuum therein to operate the electron beam guns and needs an electron beam alignment system for each of the electron beam guns to align an electron beam emitted from each of the electron beam guns. Therefore, the operating speed of the conventional alignment system considerably decreases. In addition, the conventional alignment system also needs a precision stage, which is very expensive, to precisely adjust the locations of portions of the mask over.

Conventionally, an alignment error is measured by putting the same mark on a wafer and on a mold and comparing the marks put on the wafer and on the mold compared with each other using a microscope or by carving a diffraction grating into a wafer or a wafer stage and measuring the amount of light reflected from the wafer or the wafer stage. This type of alignment error measurement technique has a resolution of about 100 nm, which is commensurate to the wavelength of light, and thus can move a wafer stage only by as much.

However, the minimum line width of semiconductor devices is expected not to be larger than 70 nm, in which case, a wafer stage needs to be moved by less than 20 nm. Thus, conventional alignment technology is expected to become obsolete in the near future. Therefore, a new alignment error measurement technique is necessary.

According to an aspect of the present invention, there is provided an alignment system used in nano-imprint lithography, which aligns a mold with a substrate. The alignment system includes: a plurality of electron emission devices, which are provided in the mold and emit electrons; and a plurality of electrodes, which are provided to face the electron emission devices and at which the electrons emitted from the electron emission devices arrive. The mold and the substrate are aligned with each other by maximizing the amount of current in each of the electrodes.

The alignment system may also include a gate layer, which is formed to have a plurality of holes so that the electrons emitted from the electron emission devices penetrate it through the holes.

The present invention thus provides an alignment system used in nano-imprint lithography, in which an electron emission device is formed in a mold and an electrode is installed on a substrate and which aligns the mold with the substrate by detecting the amount of current in the electrode generated by electrons emitted from the electron emission device, and a nano-imprint lithography method using the alignment system.

The above and other features and advantages of the present invention will become more apparent by describing in detail exemplary embodiments thereof with reference to the attached drawings in which:
FIG. 1 is a diagram illustrating an alignment system used in nano-imprint lithography, according to an exemplary embodiment of the present invention;
FIG. 2 is a cross-sectional view illustrating a mold and a substrate of FIG. 1;
FIG. 3 is a top view illustrating the mold of FIG. 2;
FIGS. 4A through 4F are cross-sectional views illustrating a method of forming the mold of FIG. 2;
FIGS. 5A through 5D are cross-sectional views illustrating a method of forming the substrate of FIG. 2; and
FIGS. 6A through 6C are cross-sectional views illustrating a method of transferring the shapes of raised patterns formed in a mold to a substrate in nano-imprint lithography using the alignment system according to an exemplary embodiment of the present invention.

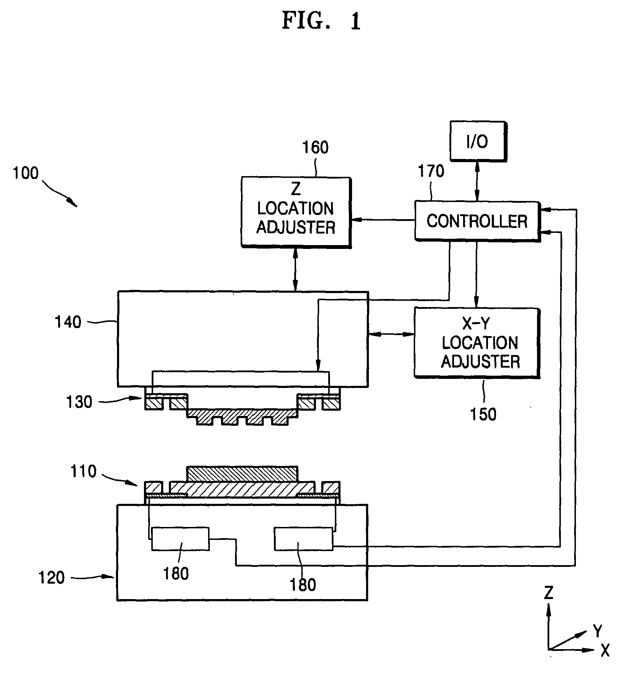

Referring to FIG. 1, an alignment system 100 includes a fixed stage 120, which supports a substrate 110, a moving stage 140, which supports a mold 130 to be capable of moving, and a controller 170, which controls an X-Y location adjuster 150 and a Z location adjuster 160 to align the substrate 110 with the mold 130.

The X-Y location adjuster 150 adjusts the location of the moving stage 140 by transferring the moving stage 140 in an X direction or a Y direction. The Z location adjuster 160 adjusts the location of the moving stage 140 by transferring the moving stage 140 in a Z direction.

The substrate 110 is connected to a plurality of current measurement units 180. The current measurement units 180 are connected to the controller 170. The current measurement units 180 measure the amount of current in the substrate 110 and transmit the measured amount of current to the controller 170.

FIG. 1 illustrates that the substrate 110 is supported by the fixed stage 120 and the mold 130 is supported to be capable of moving by the moving stage 140. However, the substrate 110 may be supported to be capable of by the moving stage 140, and the mold 130 may be supported by the fixed stage 120.

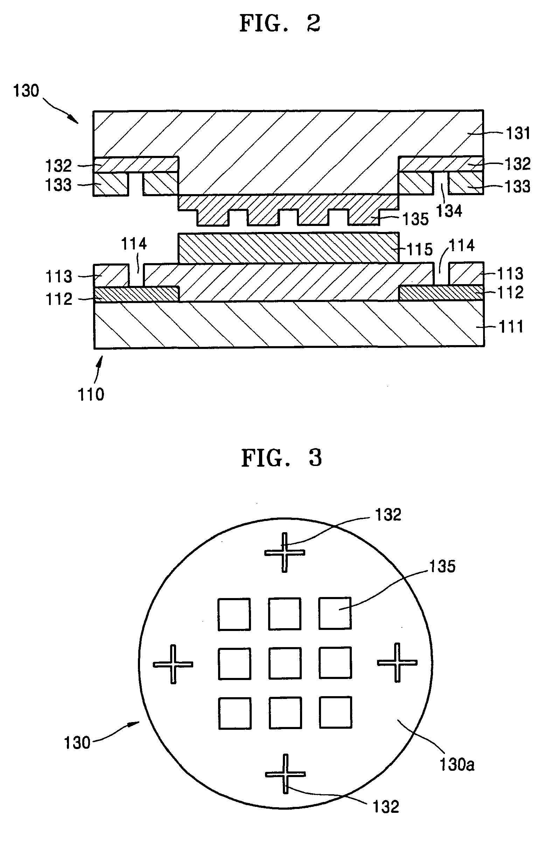

FIG. 2 is a cross-sectional view illustrating the substrate 110 and the mold 130 of FIG. 1. Referring to FIG. 2, the substrate 110 includes a main substrate layer 111, an auxiliary substrate layer 113, a thin film 115, which is formed on the auxiliary substrate layer 113 to be able to contact the mold 130, and a plurality of electrodes 112, which are provided between the main substrate layer 111 and the auxiliary substrate layer 113 surrounding the thin film 115 and are reached by electrons transferred by the mold 130. The shape of a pattern formed in the mold 130 can be transferred to the thin film 115 when the mold 130 contacts the thin film 115. Holes 114 are formed through the auxiliary substrate layer 113 so that the electrons transferred by the mold 130 penetrate the auxiliary substrate layer 113 through the holes 114.

The electrodes 112 are connected to the respective current measurement units 180 of FIG. 1. The current measurement units 180 measure the amount of current in each of the electrodes 112 generated by the electrons transmitted by the mold 130.

Referring to FIGS. 2 and 3, the mold 130 is provided to face the substrate 110. The mold 130 includes a body 131, raised patterns 135, which are formed to protrude on the body 131 at regular intervals, a plurality of electron emission devices 132, which are provided at regular intervals surrounding the raised patterns 135 and emit electrons, and a gate layer 133, which is formed on the electron emission devices 132 and has holes 134 so as to be able to pass the electrons emitted from the electron emission devices 132 therethrough.

The electron emission devices 132 are not restricted to a particular structure but may have various structures as long as they can emit electrons.

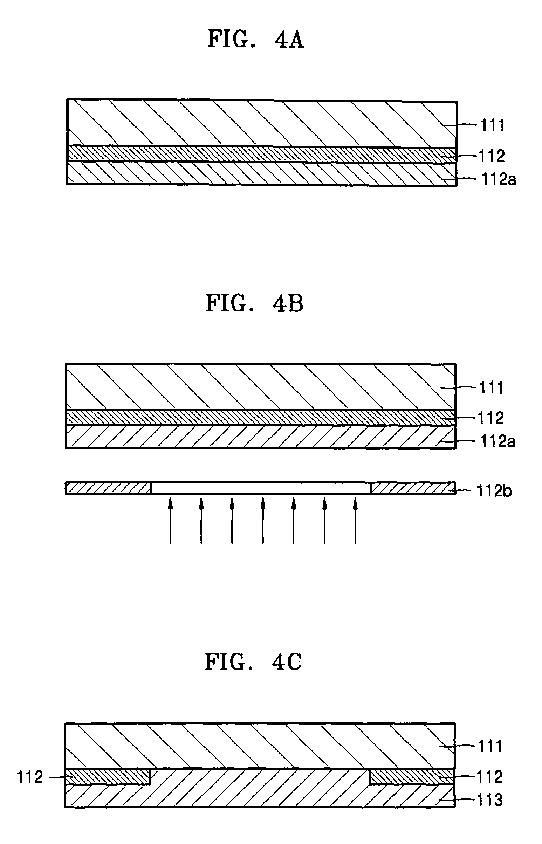

A method of forming the substrate 110 of FIG. 2 according to an exemplary embodiment of the present invention will now be described in detail with reference to FIGS. 4A through 4F.

Referring to FIG. 4A, a conductive metallic material is deposited on a main substrate layer 111, thereby forming an electrode layer 112. Photoresist 112a is formed on the electrode layer 112.

Referring to FIGS. 4B and 4C, the photoresist 112a is exposed by applying light (particularly, ultraviolet rays) using a patterned mask 112b and then is developed, thereby forming a plurality of electrodes 112. An auxiliary substrate layer 113 is deposited on the electrodes 112 and on a portion of the main substrate layer 111 exposed between the electrodes 112.

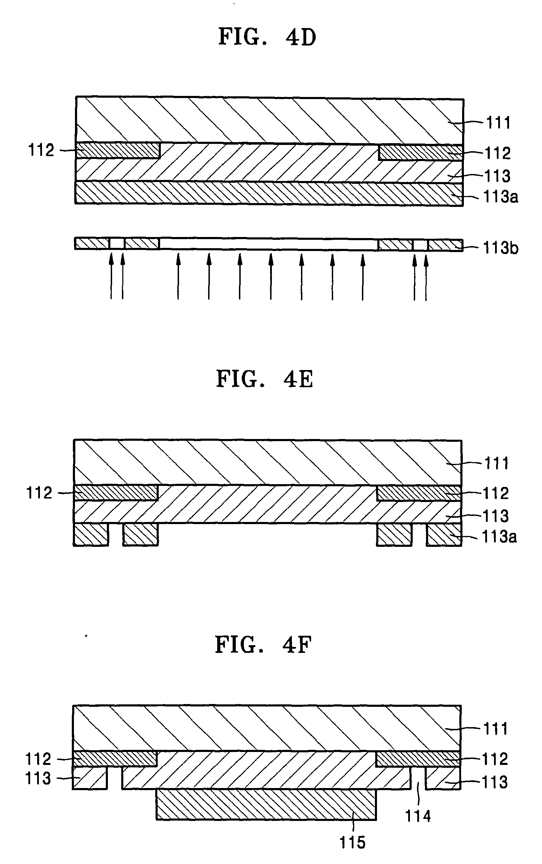

Referring to FIGS. 4D and 4E, photoresist 113a is deposited on the auxiliary substrate layer 113. The photoresist 113a is exposed by applying light (particularly, ultraviolet rays) using a patterned mask 113b and then is developed.

Referring to FIG. 4F, the auxiliary substrate layer 113 is etched, thereby forming a plurality of holes 114. Accordingly, part of each of the electrodes 112 is exposed between the holes 114, and the formation of the substrate 110 is complete.

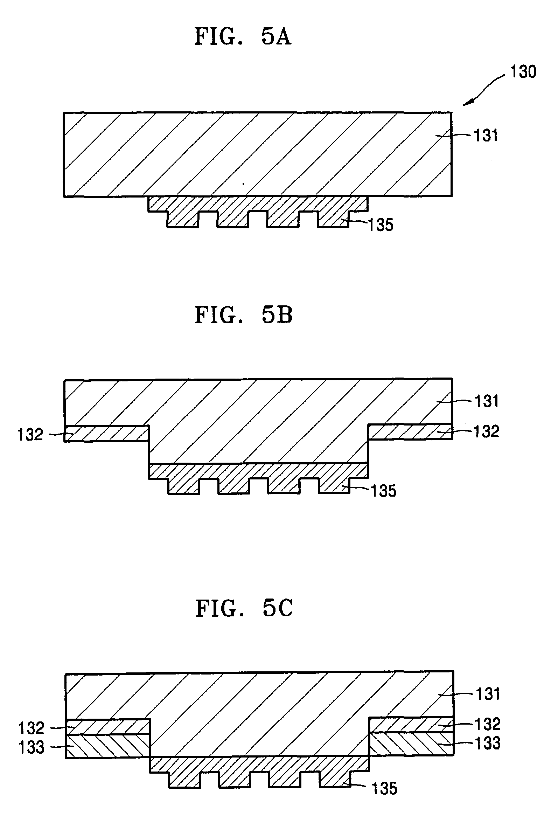

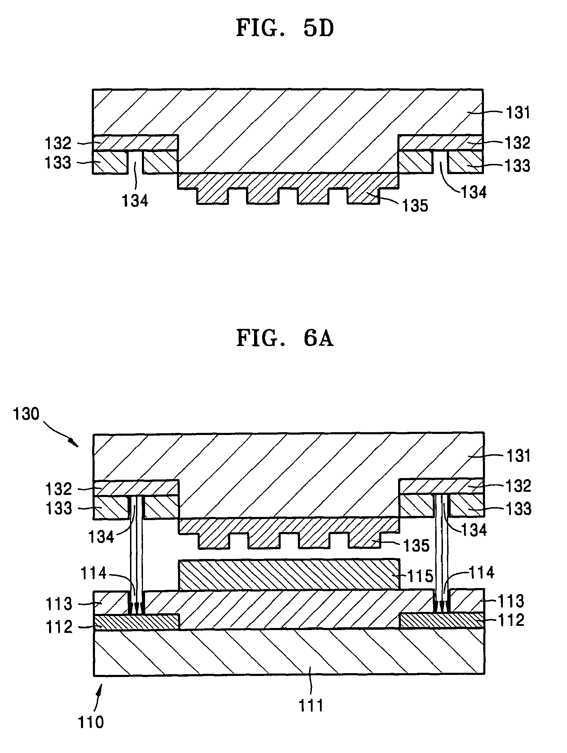

A method of forming the mold 130 of FIG. 2 according to an exemplary embodiment of the present invention will now be described in detail with reference to FIGS. 5A through 5D.

Referring to FIG. 5A, raised patterns 135 are formed on the bottom surface of a body 131 by using a typical patterning method. A detailed description of the typical patterning method will be skipped.

Referring to FIG. 5B, the body 131 outside the raised patterns 135 is etched to a predetermined depth, and a plurality of electron emission devices 132 are formed on the body 131 to surround the raised patterns 135. The electron emission devices 132 may have various structures as long as they can emit electrons. Thus, a detailed description of a method of forming the electron emission devices 132 will be skipped.

Referring to FIG. 5C, a gate layer 133 is formed by patterning upper portions of the electron emission devices 132, and a plurality of holes 134 are formed through the gate layer 133 so that electrons emitted from the electron emission devices 132 penetrate the gate layer 133 therethrough. Part of each of the electron emission devices 132 is exposed between the holes 134. The electrons emitted from the electron emission devices 132 are transferred to the substrate 110 of FIG. 2 via the holes 134.

A method of transferring the shapes of raised patterns formed in a mold to a substrate in nano-imprint lithography using an alignment system according to an exemplary embodiment of the present invention will now be described in detail.

Particularly, a method of aligning the substrate 110 with the mold 130 in the alignment system of FIG. 1 will now be described in detail with reference to FIGS. 1 and 6A.

Referring to FIGS. 1 and 6A, the controller 170 controls the electron emission devices 132 to emit electrons.

Electrons emitted from the electron emission devices 132 penetrate the gate layer 133 through the holes 134 formed in the gate layer 133, penetrates the auxiliary substrate layer 113 of the substrate 110 via the holes 114 formed in the substrate 110, and then reach the electrodes 112. When the electrons emitted from the electron emission devices 132 reach the electrodes 112, a current flows in each of the electrodes 112. The current measurement units 180 measure the amounts of current in the respective electrodes 112.

The controller 170 compares each of the measured amounts of current with a reference value previously stored therein and aligns the holes 134 formed through the gate layer 133 with the holes 114 formed through the auxiliary substrate layer 113 by appropriately moving the X-Y location adjuster 150 in the X direction or in the Y direction.

When the holes 134 formed through the gate layer 133 are precisely aligned with the holes 114 formed through the auxiliary substrate layer 113, the amount of electrons that arrive at the electrodes 112 from the electron emission devices 132 can be maximized. In other words, when the amount of electrons that arrive at the electrodes 112 from the electron emission devices 132 is maximized, it appears that the holes 134 formed through the gate layer 133 are precisely aligned with the holes 114 formed through the auxiliary substrate layer 113. When the holes 134 formed through the gate layer 133 are precisely aligned with the holes 114 formed through the auxiliary substrate layer 113, it appears that the substrate 110 is precisely aligned with the mold 130.

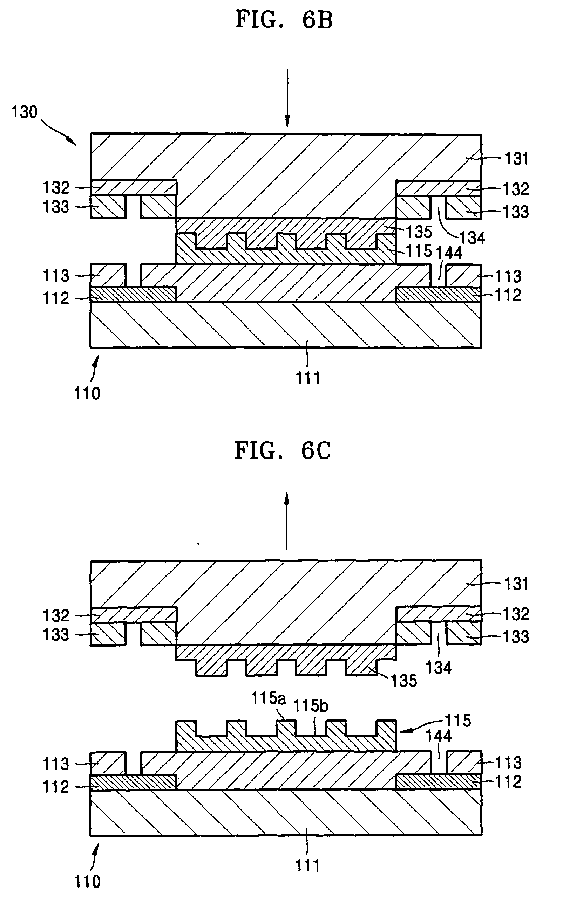

Referring to FIGS. 1 and 6B, the controller 170 controls the Z location adjuster 160 to lower the moving stage 140 so that the raised patterns 135 firmly contact and thus pressurizes the thin film 115. Accordingly, the shapes of the raised patterns 135 are transferred to the thin film 115.

Referring to FIGS. 1 and 6C, the controller 170 controls the Z location adjuster 160 to lift the moving stage 140 so that the mold 130 and the raised patterns 135 formed in the mold 130 are separated from the substrate 110.

Then, the shapes of the raised patterns 135 are left on the thin film 115 so that the thin film 115 is comprised of non-recessed portions 115a and recessed portions 115b.

As described above, the alignment system used in nano-imprint lithography according to the present invention has the following advantages.

First, since the alignment system used in nano-imprint lithography according to the present invention does not use a light source, its resolution is not affected at all by the wavelength of the light source.

Second, the alignment system used in nano-imprint lithography according to the present invention can align a mold with a substrate with a high precision based on a result of measuring the amount of current in an electrode of the mold generated by electrons emitted from an electron emission device.

Third, since the alignment system used in nano-imprint lithography according to the present invention can determine its resolution based on the width of an alignment mark, it can maximize the precision of the alignment of the mold with the substrate.

## Claims

1. An alignment system for use in nano-imprint lithography for aligning a mold with a substrate, the alignment system comprising:
a plurality of electron emission devices provided in a mold for emitting electrons; and
a plurality of electrodes associated with a substrate, the electrodes being arranged to face the electron emission devices such that electrons emitted from the electron emission devices arrive at the electrodes,
wherein the electron emission devices and the plurality of electrodes are arranged such that the mold and the substrate can be aligned with each other by maximizing an amount of current generated in each of the electrodes.

2. The alignment system of claim 1, further comprising a gate layer having a plurality of holes arranged so that electrons emitted from the electron emission devices penetrate through the holes.

3. The alignment system of claim 1 or 2, wherein a plurality of holes are formed through the substrate so that electrons emitted from the electron emission devices can penetrate the substrate therethrough and can arrive at the electrodes.

4. The alignment system of any preceding claim, wherein the electron emission devices are formed inside the mold, and the electrodes are formed inside the substrate.

5. The alignment system of any preceding claim, further comprising a plurality of current measurement units arranged to measure the amounts of current in respective electrodes generated by electrons emitted from the electron emission devices.

6. The alignment system of claim 5 further comprising a controller arranged to align the mold with the substrate by adjusting the location of the mold or the location of the substrate until the measured amounts of current reach a reference value.

7. The alignment system of claim 6, wherein the controller adjusts the location of the mold or the location of the substrate.

8. The alignment system of any preceding claim, wherein the electron emission devices are formed outside a plurality of raised patterns formed in the mold.

9. A nano-imprint lithography method comprising:
aligning a mold having a plurality of electron emission devices therein with a substrate having a plurality of electrodes therein; and
transferring raised patterns formed on the mold to the substrate by making the mold become in contact with the substrate.

10. The nano-imprint lithography method of claim 9, wherein the aligning of the mold with the substrate comprises:
preparing the mold in which the electron emission devices are formed;
preparing the substrate in which the electrodes corresponding to the electron emission devices are formed; and
aligning the mold with the substrate by adjusting the location of the mold or the location of the substrate so that the amount of current in each of the electrodes generated by electrons emitted from the electron emission devices can be maximized.

11. The nano-imprint lithography method of claim 10, wherein preparing the mold comprises:
forming the electron emission devices outside the raised patterns; and
patterning upper portions of the electron emission devices and thus forming a gate layer to have a plurality of holes so that electrons emitted from the electron emission devices can penetrate through the holes.

12. The nano-imprint lithography method of claim 10 or 11, wherein preparing the substrate comprises:
forming a plurality of electrodes by depositing a metallic material on a main substrate layer and patterning the deposited metallic material; and
forming a plurality of holes through the substrate by depositing an auxiliary substrate layer on the electrodes and patterning the auxiliary substrate layer.

13. The nano-imprint lithography method of any of claims 10 to 12, wherein, in aligning the mold with the substrate, a plurality of current measurement units, which are connected to respective electrodes, measure the amounts of current in the respective electrodes, and the mold and the substrate are aligned with each other by adjusting one of their locations until the measured amounts of current reach a reference value.
